# EUROPEAN PATENT SPECIFICATION

(11) **EP 0 342 537 B1**
(45) Date of publication and mention of the grant of the patent: **06.09.1995**
(21) Application number: 89108558.1
(22) Date of filing: 12.05.1989
(51) Int. Cl.: C23C 14/34, C23C 14/08

(54) **Process for the manufacture of a sputtering target for producing electroconductive transparent films**
Verfahren zur Herstellung eines Sputtertargets zur Erzeugung einer elektrisch leitenden, durchsichtigen Schicht
Procédé de fabrication d'une cible de pulvérisation pour produire un film électroconductif et transparent

(30) Priority: 16.05.1988 JP 117136/88; 16.05.1988 JP 117137/88; 16.05.1988 JP 117138/88
(43) Date of publication of application: 23.11.1989
(73) Proprietor: Tosoh Corporation, Shinnanyo-shi Yamaguchi-ken (JP)
(72) Inventor: Iwamoto, Tetsushi, Yamagata-shi Yamagata-ken (JP); Yoshida, Yasunobu, Yamagata-shi Yamagata-ken (JP); Furuto, Toshiaki, Yamagata-shi Yamagata-ken (JP); Sudo, Koichi, Yamagata-shi Yamagata-ken (JP)
(74) Representative: Kügele, Bernhard

(56) References cited:
- EP-A- 0 115 629
- GB-A- 2 058 142
- JAPANESE JOURNAL OF APPLIED PHYSICS, vol. 17, no. 7, July 1978, pp. 1191-1196 ; K. ITOYAMA : "Properties of Sn-doped indium oxide prepared by high rate and low temperature RF sputtering"
- VAKUUM-TECHNIK, 33. Jahrgang, Heft 1, 1984 ; R.A. Lang Verlag, Idstein, Deutschland, Seiten 3-9 ; H.G. SEVERIN : "Materialen für die Kathoden-Zerstäubung"

## Description

### Background of the Invention :

### Field of the Invention :

The present invention relates to a method of manufacturing sputtering targets from a mixture comprising at least 70% by weight of indium oxide, and tin oxide, comprising the preparation of a slurry of indium oxide and tin oxide in form of powders with water, a dispersing agent and a binder, molding of said slurry and sintering of the resulting shape.

### Description of the Related Arts:

Recent developments in the technology of making thin films has accelerated use of electroconductive transparent films in the field of displaying elements and the like. At present, as materials for making electroconductive transparent films, there are known various oxides such as indium oxide-tin oxide (hereinafter designated as ITO), tin oxide-antimony oxide, and zinc oxide, metals such as gold, platinum and silver, and non-oxide materials such as chalcogenides, lanthanum boride, and titanium nitride. Among them, however, ITO is the most commonly used because of its stability and high degree of light transmittance. Meanwhile, the electroconductive transparent films from ITO are known to be produced by the vacuum evaporation method, the reactive sputtering process using an indium-tin metal target and the sputtering process employing a target which contains ITO (hereinafter designated as ITO target). The sputtering proccess using the ITO target is the most popular because of the easy control of formed films.

However, the sputtering is usually conducted on a target with a plasma controlled by a magnet. When a conventional ITO target having a flat plate shape is employed, the target will be eroded according to the shape of said magnet and therefore the utility efficiency of the target is lowered to 20 to 40%. This will cause a problem. But the utility efficiency may be increased if the used ITO target is recovered, dissolved and purified to obtain regenerated powders and a new target is prepared from said powders. However, the quality of the target prepared with the regenerated powders is inferior.

On the other hand, conventional ITO targets were prepared by molding powders containing ITO (hereinafter designated as ITO powder) by a metal press molding process to obtain a molded shape containing ITO (hereinafter called ITO molding) and then sintering said shape.

However, the problem is that uniform pressing for obtaining an ITO shape is difficult with the metal press molding process. When a larger target is to be prepared which is required for a sputtering apparatus of a larger scale, a target thus prepared may warp or crack, giving a problem. Therefore, in order to overcome the problems of warp and crack, a common practice for preparing large target is such that a plurality of precious metal mold components are prepared for every different shape of an object target to obtain fractions of the object target and these fractions thus prepared are joined together into a complete shape. The large scale targets thus prepared still have a problem that extraordinary electric discharges may happen at the joints.

Further, indium oxide and tin oxide are not readily sintered and therefore the ITO target obtained by the above method has a disadvantage that the relative density is less than 70%. Usually a target of a lesser relative density shoes high electric resistance, weak resistance against bending and low thermal conductivity. When sputtering is conducted with such targets, it is known an extraordinary electric discharge often happens which most likely causes adverse effect on the electroconductive transparent film on the ITO thus prepared.

EP-A-0 115 629 discloses a ceramic target for cathodic sputtering based on a mixture of tin oxide and indium oxide, which was produced by hot pressing of the oxide mixture, yielding about 75% theoretical density.

An article entitled "Properties of Sn-Doped Indium Oxide Prepared by High Rate and Low Temperature RF Sputtering" published in Japanese Journal of Applied Physics, Vol. 17, No. 7, July 1978, pages 1191-1196 describes obtaining a film of indium-tin oxides on a glass substrate by using an ITO target including 5% tin oxide in a paste of indium oxide and water. The paste was then heated for 1 hour at 500°C.

An article entitled "Materialien für die Kathoden-Zerstäubung" published in Vakuum-Technik, 33 Jahrgang, Heft 1, discloses the production of indium/tin oxide sputtering targets in particular shapes in order to improve their degree of utilization.

### Summary of the Invention:

The object of the present invention is to provide a process for manufacturing ITO sputtering targets of a larger scale or a higher relative density or a higher utility efficiency.

This objective is obtained by a method as mentioned above which is further characterized in that said molded slurry is Subsequently subjected to cold hydrostatic pressing under a pressure of at least 1 ton/cm², and in that said mould is a water-absorbing porous mould.

### Detailed Description of the Invention :

After intensive investigations to obtain an ITO sputtering target of high utility efficiency, the present inventors succeeded in improving also the utility efficiency of ITO sputtering targets by changing their shape. The improvement of the utility efficiency of ITO sputtering target has long been needed but has not been successfully achieved.

An improved process should permit to produce a sputtering target for producing electroconductive transparent films containing indium oxide-tin oxide which is such a shape that not less than 80% by weight of said target is present in the erosion area on sputtering.

According to the process of the present invention, one may produce ITO targets which contain both indium oxide (In₂O₃) and tin oxide (SnO₂) and the indium oxide content is usually not less than 70% by weight. Further, presence of a third component other than oxides of indium and tin is permitted if it is useful for improving the electroconductivity or the transparency of electroconductive transparent films obtainable from said target.

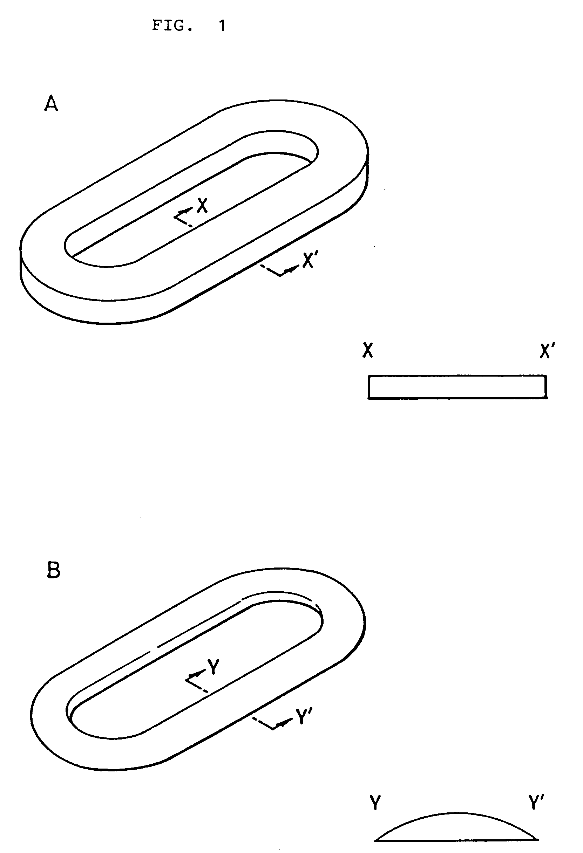

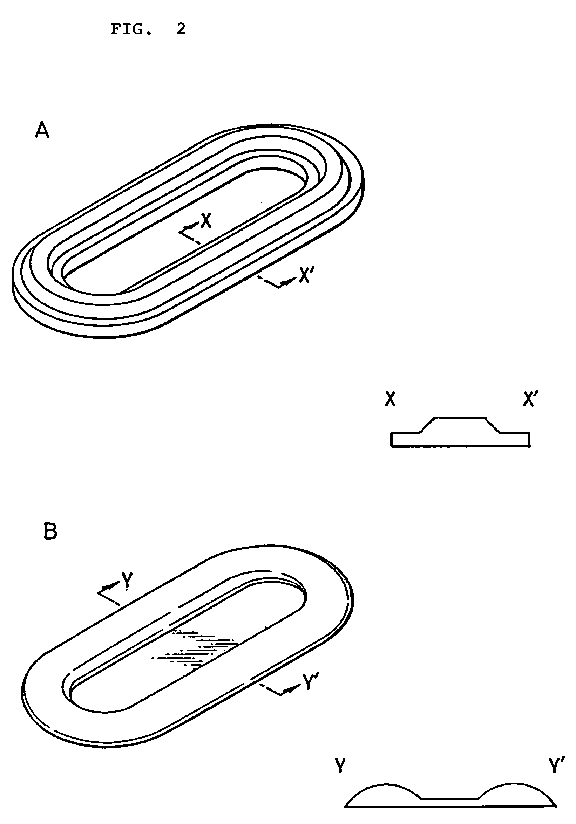

The shape of the target is not particularly restricted as long as not less than 80% by weight of the target is present within the erosion area on sputtering. These targets can be exemplified, for instance, by those loop shapes shown in Fig. 1 of which the cross-section is rectangular or curved like a bow and those loop or plane shapes shown in Fig. 2 of which the thickness varies according to the degree of erosion they are supposed to suffer from on sputtering. Among them loop shapes are preferred due to their high utility efficiency.

The target is usually bonded with a cooling metal plate (backing plate) by soldering to keep the target cool. It is recommended to make flat the plane which bonds with the backing plate to maintain the tight bonding and to improve the cooling efficiency of the target.

If the target is prepared in the shape as mentioned above, most part of the surface of ITO works efficiently on sputtering, leading to improve the utility efficiency of the target.

The target referred to above is produced according to the invention by a method in which a shape containing indium oxide-tin oxide is molded by a slurry casting process, wherein said molded shape is compressed with a cold hydrostatic press and then the shape is sintered.

The ITO targets, are prepared by the mentioned method, and are bonded by a soldering metal or the like with a cooling metal plate and then used for sputtering.

Loop-shaped targets may be employed on the baking plate with a vacant area covered by a sintered composition or an indium sheet, to avoid possible contamination by impurities.

The slurry casting process for molding is a method in which powders of the starting material are mixed with a solvent, a dispersing agent and a binder and the resultant slurry is injected with or without a pressure into a water-absorbing porous molding such as a molding made of gypsum and then the solvent is removed, to obtain a final shape. This process permits the ITO molding of a desired shape to be obtained merely by changing the shape of the porous molding and thus enables the production of ITO targets. For the slurry casting, water is used as the solvent for the slurry. The dispersing agent is, for example, selected from polycarboxylic acids and the binder is selected, for example, from acrylic emulsions, though not specifically limited.

As the powders of starting material, used is the powder of ITO obtained by the mixing or coprecipitation method or the like, and the powder composition is selected so as to be the same as that of the desired target. Concentration of the slurry is preferred to be not less than 70%, more preferably 75 - 80%. If the concentration is lower than 70%, the resultant target is liable to crack in the course of preparation. In addition, it is desired that the slurry is injected into a mold by the pressured casting under a pressure of not less than 0.5 kg/cm², more preferably not less than 2.0 kg/cm² , since the targets thus prepared are denser and suffers less warping.

Targets of relatively larger densities can be preferably obtained if molded shapes are compressed into a denser state before they are sintered into ITO moldings.

The compression by pressure to obtain a denser product is realized by a cold hydrostatic press which applies a pressure not less than 9.8 x 10⁷ pascal (1 tonne/cm²), more preferably 29.4 x 10⁷ pascal (3 tonnes/cm²) - 49 x 10⁷ pascal (5 tonnes/cm²). In this way a denser ITO molded shape which has been compressed by a cold hydrostatic press gives on sintering an ITO target of a larger relative density. In case when the applied pressure is less than 9.8 x 10⁷ pascal (1 tonne/cm²), the sintered target might not be improved with respect to the relative density.

Then the molding of ITO mentioned above is sintered to obtain an ITO target of the desired shape. The sintering is preferably conducted at a temperature 1300 - 1450°C for an hour.

The process for manufacturing a sputtering target for producing electroconductive transparent films containing indium oxide-tin oxide, which comprises obtaining a molded shape that contains indium oxide-tin oxide by the slurry casting process, can be applied to manufacture an ITO target of a desired shape by changing the shape of the porous molding to be used in the slurry casting molding, as well as the ITO target itself.
Further, as the slurry casting process gives molded shapes of an approximately uniform density, targets of a desired dimension can be produced without suffering any crack and bending even if production of larger products are intended.

The ITO targets prepared by the process mentioned above have relative densities of 70% or larger and good characteristics as target.

### Brief Explanation of Drawings:

Figs. 1 and 2 show some shapes of the ITO target manufactured according to this invention.

Figs. 3 and 4 show shapes of the master for making a gypsum mold and the target obtained therefrom.

### Description of Preferred Embodiments:

The present invention will be described in more details by referring to examples, but the invention is not limited to them.

### Example 1

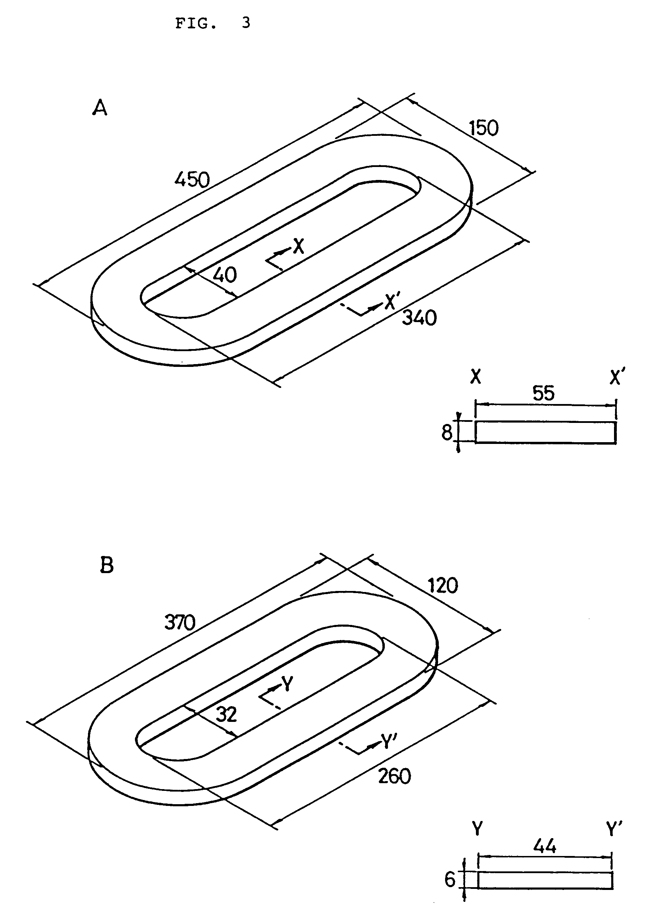

An 8 mm thick board made of polyacrylate was processed into the shape shown in Fig. 3A and a gypsum mold was formed using said board as a master mold.

A mixture consisting of 1170 g of commercial indium oxide powder and 130 g of tin oxide powder (or 1300 g of a starting material powder), 25 g of polycarboxylic acid dispersing agent (containing 40% of solid matter), 25 g of acrylic emulsion binder (with 40% of solid matter) and 400 g of pure water was placed in a nylon pot of 3 liter capacity, and the whole mixture was thoroughly mixed for 16 hours with a rotating ball mill using iron-cored resin balls of a 15 mm diameter, to obtain a slurry.

The slurry obtained was thoroughly de-aired and poured into said gypsum mold under the normal pressure for casting, to obtain a molded shape.

The molded shape thus obtained was made denser under pressure of 29.4 x 10⁷ pascal (3 tonnes/cm²) with a cold hydrostatic press to remove the binder and then sintered at 1350°C for 3 hours. The sinter thus obtained was worked by discharging and plane shaving, to obtain an ITO target having the shape in Fig. 3B.

Using the target prepared above, a sputtering test was conducted with the sputtering apparatus and the conditions therefor shown in Table 1. In the test, the target was bonded to a backing plate by use of an indium solder and the portion which was void of material was covered by an indium sheet. As a result, the utility efficiency of the target obtained amounted to 52.0%.

### Example 2

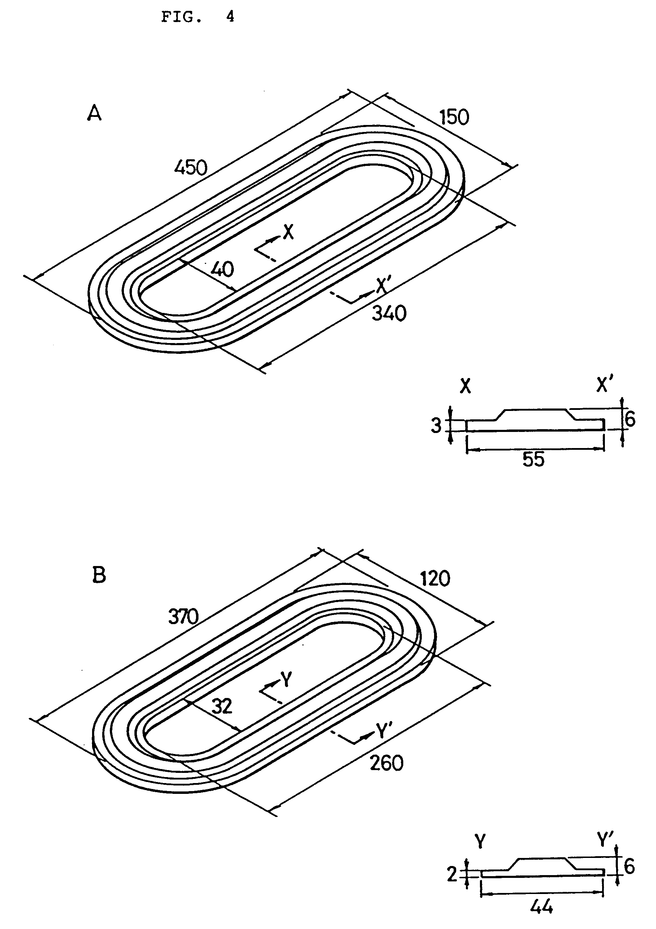

Using the same method as in Example 1 except that the acrylic board shown in Fig. 4A was used as a master mold for the gypsum mold and a pressure of 49 x 10⁷ pascal (5 tonnes/cm²) was applied to the cold hydrostatic press, a target of the shape shown in Fig. 4B was prepared and the sputtering test was conducted. In this test were employed 900 g powder of the starting material, 20 g of a dispersing agent, 20 g of a binder and 220 g of water. As a result, the utility efficiency of the target thus prepared was 74.4%.

**Table 1**

| | |
|---|---|
| Size of target employed | 127 x 381 x 6 mm (thickness) |
| Method of sputtering | DC magnetron sputtering |
| Power applied | 1 kW |
| Sputtering atmosphere | Argon (0.8 Pa) |

### Comparison Example 1

A mixture consisting of 4950 g of commercial indium oxide powder, 550 g of tin oxide powder, 100 g of a polycarboxylic acid dispersing agent (containing 40% of solid matter), 100 g of an acrylic emulsion binder (with 40% of solid matter) and 1740 g of pure water was placed in a nylon pot of 10 liter capacity and thoroughly mixed for 16 hours together with iron-cored resin balls of a 15 mm diameter in a rotating ball mill, to obtain a slurry.

Subsequently, the slurry thus obtained was thoroughly de-aired and poured into a gypsum mold (180 x 1080 x 10t (t=thickness) in inner dimensions) and molding was carried out according to the casting process, to obtain an ITO molding.

Then the binder was removed from the molded shape obtained and the resulting molded shape was sintered at 1350°C for 3 hours. The obtained sinter was worked by electrical discharge and plane shaving, to obtain an ITO target (150 x 900 x 6t (t=thickness)). The relative density of the target obtained was 60%.

### Comparison Example 2

A mixture consisting of 1900 g of commercial indium oxide powder and 100 g of tin oxide powder was placed in a nylon pot of a 5 liter capacity and thoroughly mixed for 16 hours in a dry condition together with iron-cored resin balls of a 15 mm diameter in a rotating ball mill, to obtain an ITO powder.

Then 45 g of powdered paraffin was added to 1500 g of the ITO powder obtained above. The whole was placed in a 260 mm diameter metal mold and preliminarily molded in the metal press molding with a pressure of 100 kg/cm² , to obtain an ITO molded shape.

Subsequently, the molding obtained was made denser by a pressure of 49 x 10⁷ pascal (5 tonnes/cm²) using a cold hydrostatic press, removed of the binder, sintered at 1350°C for 5 hours, to obtain an ITO sinter, which was worked with electrical discharge and place shaving to obtain an ITO target of a dimension 203 mm in diameter and 6 mm in thick.

The relative density of the target obtained was 78.9%.

### Example 3

A mixture consisting of 2250 g of commercial indium oxide, 250 g of tin oxide, 56.25 g of polycarboxylic acid dispersing agent (with 40% of solid matter), 56.25 g of an acrylic emulsion binder (with 40% of solid matter) and 569 g of pure water was placed in 10 liter nylon pot and the whole was thoroughly mixed for 16 hours together with iron-cored resin balls of 15 mm diameter in a rotating ball mill, to obtain a slurry.

The slurry obtained was thoroughly de-aired and then poured into a gypsum mold (160 x 480 x 10t (t=thickness)) for conducting the preliminary molding by the pressurized casting process, to obtain an ITO molded shape.

Then the molded shape prepared was made denser by compressing under a pressure of 49 x 10⁷ pascal (5 tonnes/cm²), removed of binder and sintered at 1350°C for 5 hours, to obtain an ITO sinter, which was worked by the electrical discharge and plane shaving into an ITO target (127 x 381 x 6t (t=thickness)).

The relative density of the target prepared was 76.8%. The rate of resistance, the anti-bending strength and the thermal conductivity of the target were estimated. Results are shown in Table 2.

### Comparison Example 3

An ITO target was prepared in the same method as in Example 1 except that a cold hydrostatic press was not used.

The relative density of the target prepared was 62.0%.

As has been mentioned above, the utility efficiency of a target on sputtering can be improved according to the invention of this application.

Further, the decreased amount of the materials required for the preparing a target enables to cut down the cost of the target and the unit price per unit area of electroconductive transparent films when completed.

Further, the invention provides a process by which a large ITO target of an arbitrary shape can be prepared in a simple and convenient process. Also since a large target can be prepared without any bonding, there is no fear of possible melting of soldering materials and accompanying abnormal electrical discharges. Thus, electroconductive transparent films of high quality can be formed.

Furthermore, ITO targets of relative density larger than 70% are prepared by applying the cold hydrostatic press to an ITO molding, followed by sintering. The targets thus prepared are excellent in the rate of resistance, the anti-bending strength and the thermal conductivity, and allow high stability of electrical discharge on sputtering. In addition, the high density of targets introduces a high rate of sputtering, leading to the high productivity in making films.

## Claims

1. A method of manufacturing a sputtering target from a mixture comprising at least 70% by weight of indium oxide, and tin oxide, comprising the preparation of a slurry of indium oxide and tin oxide in form of powders with water, a dispersing agent and a binder, molding of said slurry and sintering of the resulting shape, characterized in that said molded slurry is subjected to cold hydrostatic pressing under a pressure of at least 9.8 x 10⁷ Pa (1 tonne/cm²), and in that the mould is a water-absorbing porous mould.

## Patentansprüche

1. Verfahren zur Herstellung eines Sputtertargets aus einer Mischung, welche zumindest 70 Gewichts-% Indiumoxyd und Zinnoxyd enthält, welches die Zubereitung einer Aufschlämmung von Indiumoxyd und Zinnoxyd in Form von Pulvern mit Wasser, einem Dispergiermittel und einem Binder, das Gießen der Aufschlämmung und das Sintern der sich ergebenden Gestalt umfaßt, dadurch gekennzeichnet, daß die gegossene Aufschlämmung einem kalthydrostatischen Pressen bei einem Druck von wenigstens 9,8 x 10⁷ Pa (1 Tonne/cm²) unterworfen wird, und daß die Gießform eine wasserabsorbierende, poröse Gießform ist.

## Revendications

1. Procédé de fabrication d'une cible de pulvérisation à partir d'un mélange comprenant au moins 70 % en poids d'oxyde d'indium et d'oxyde d'étain, comprenant les opérations consistant à préparer une boue d'oxyde d'indium et d'oxyde d'étain sous forme de poudre avec de l'eau, un agent de dispersion et un liant, à mouler ladite boue et à fritter la forme obtenue, caractérisé en ce que ladite boue moulée est soumise à une presse hydrostatique à froid sous une pression d'au moins 9,8 x 10⁷ pa (1 tonne/cm²) et en ce que le moule est un moule poreux absorbant l'eau.
